# EUROPEAN PATENT SPECIFICATION

(11) **EP 0 361 507 B1**
(45) Date of publication and mention of the grant of the patent: **07.06.1995**
(21) Application number: 89118042.4
(22) Date of filing: 29.09.1989
(51) Int. Cl.: B23K 35/38, B23K 1/00

(54) **Process for reflow coating using an atmosphere having a controlled oxidation capability**
Verfahren zum Schmelzbeschichten in einer Atmosphäre mit gesteuerter Oxydationsfähigkeit
Procédé pour revêtir par refusion dans une atmosphère à oxydation contrôlée

(30) Priority: 30.09.1988 US 251259
(43) Date of publication of application: 04.04.1990
(73) Proprietor: PRAXAIR TECHNOLOGY, INC., Danbury, CT 06810-5113 (US)
(72) Inventor: Nowotarski, Mark Stephen, Ossining NY 10562 (US)
(74) Representative: Schwan, Gerhard, Dipl.-Ing.

(56) References cited:
- GB-A- 2 171 042
- US-A- 3 882 596
- US-A- 4 610 391
- PATENT ABSTRACTS OF JAPAN, vol. 11, no. 318 (M-632), 16th October 1987; & JP-A-62 101 372 (TAMURA SEISAKUSHO CO: LTD) 11.5.1987
- WELDING PRODUCTION, vol. 31, no. 8, August 1984, pages 38-39, Abington,Cambridge, GB; S.A. FEDOROV et al.: "Properties of welded joints in corrosionresisting steels produced by a light beam in nitrogen-oxygen mixtures"

## Description

This invention relates to a method of reflow coating wherein the oxygen concentration of the atmosphere surrounding the coating operation is controlled to provide improved wetting between a metal-comprising coating material and a metal-comprising substrate to which the metal-comprising coating material is to be applied. The method can be optimized to provide improved wetting of the substrate while simultaneously reducing metal oxide generation rates.

In recent years, numerous methods have been developed to provide for improved joining of or coating of metal-comprising substrates. The joining or coating is typically conducted in the presence of a fluxing agent which is used to react with or dissolve and wash away compounds which are detrimental to wetting of the substrate surfaces which are to be joined or coated. However, fluxing agents are typically corrosive and residues must be removed from workpieces after the joining or coating operation. In addition, should the amount of flux be insufficient, the metal-comprising filler used for joining or the metal-comprising coating material can form icicles on the part as the part is removed from the joining/coating bath; wetting time may be inadequate within the process so that poor bonding between metal-comprising filler/coating material and metal-comprising substrate occurs; and metal oxide formation (dross) production during the joining/coating operation may be rapid, leading to heavy maintenance requirements.

Attempts have been made to solder or coat metallic substrates without a flux. If a substrate surface which can be wetted by the solder/coating is provided and the solder/coating operation is carried out in an inert atmosphere, such as an oxygen-free atmosphere, it is possible to solder/coat the metallic substrate without a flux. However, fluxless soldering in an inert atmosphere does not always provide adequate wetting of the metallic substrate. The viscosity and surface tension of the metal-comprising filler material causes such material to form droplets and pull away from the metallic substrate which must be well contacted by the metal-comprising filler material to obtain a good bond between such material and the substrate. The pulling away of the metal-comprising filler material from the substrate is frequently referred to as dewetting. The wetting ability of the metal-comprising filler material has been increased by adding wetting agents such as bismuth, strontium, barium, berillium, and antimony to the metal-comprising filler material. However, these wetting agents are expensive, sometimes generate toxic fumes, and can form undesirable compounds, such as brittle inter-metallics, within the solder (which weaken the solder).

Typical of the known art in this area are the following United States patents.

US-A-3,882,596 discloses a method for flux free soldering of aluminum-containing workpieces in a controlled atmosphere. The controlled atmosphere is free of contaminants such as ceramic materials, asbestos, grease, oil, rubber or plastic materials and is preferably of low oxygen content. Liquid purified nitrogen which has been vaporized is recommended as the controlled atmosphere.

US-A-3,900,151 discloses a method for flux free soldering of aluminum-containing workpieces in a non-oxidizing atmosphere or a low-oxygen-content atmosphere, wherein aluminum and beryllium wetting agents are added to the solder. The solder is a zinc based solder.

US-A-4,121,750 discloses processes and compositions for soldering aluminum-containing workpieces. The soldering is carried out in a substantially non-oxidizing atmosphere. The solder may be used with or without flux, and a filler material comprising an aluminum containing from 6 to 20% by weight of silicon and from 0.01 to 10% by weight of an aluminum wetting agent selected from the group consisting of bismuth, antimony, strontium and barium is interposed between the workpieces to be joined.

US-A-4,538,757 describes a method of wave soldering in an enclosure which is substantially free of oxygen. A gaseous reducing agent such as hydrogen is added to the oxygen-free atmosphere in the enclosure to provide a fluxing action during the soldering operation.

US-A-4,606,493 discloses a method of preventing oxidation of printed circuit board metal surfaces while reducing thermal stress of the board and components during soldering. Soldering is carried out in a reaction chamber which is pressurized with inert gas which seals the reaction chamber from ambient air.

The U.S. Patents listed above which relate to soldering either state directly or infer that the oxygen content of the soldering atmosphere should be free of oxygen entirely or that the oxygen concentration should be reduced to the minimum practical. In addition, several of the methods described require presence of a reducing soldering atmosphere, or the addition of wetting compounds to the solder/coating material.

In addition, GB-A-2 171 042 discloses an apparatus for wire bonding semiconductor chip connections. The apparatus uses an electric discharge to melt a fine metal wire into a ball shape; the ball of metal is subsequently pressed into the connections area, wherein the metal flows under pressure to form a bond. It is desired to have the metal which is pressed into the connections area be substantially free of oxides and impurities. This is accomplished using one of two methods: 1) When a fine wire of pure silver is used, the oxygen content of the atmosphere surrounding the electric discharge area in which the metal ball is formed is maintained at no more than 100 ppm. or, 2) When the metal wire is not a pure metal but has selected metal impurities added to it to increase the wire tensile strength, the oxygen content of the atmosphere surrounding the electric discharge area is maintained at 100 ppm to 300 ppm. In this second method, the metal impurities are deposited as oxides on the surface of the molten metal ball, so that when the ball is pressed into the connections area, the pure metal inside the ball forms a better bond in the contacting area.

JP-A--62 101 372 discloses a method and an apparatus for wave soldering. It is stated that when soldering is carried out in air, the oxidation induced by atmospheric oxygen on the surface of the molten solder and on the solder in the soldering tank prevents good soldering. Therefore it is aimed at establishing an upper oxygen concentration limit for good soldering. For this pupose the known wave soldering apparatus is provided with a soldering chamber and front and rear chambers disposed at the inlet and the outlet side, respectively, of the soldering chamber. Inert gas from an inert gas tank, upon being heated, is pumped into the soldering chamber whilst cooled inert gas is pumped into the rear chamber. The chambers are separated from each other by gates which open when workpieces are fed from one to the next chamber. When the gate between the front and solder chambers opens, inert gas passes from the solder chamber to the front chamber and displaces the air therein. Gas outlets of the front and rear chambers communicate with the suction side of the inert gas pump through an oxygen absorbing agent tank and a filter thereby providing for an inert gas recirculation circuit. When the oxygen concentration in the environment around the soldering section above a soldering tank is reduced to less than an upper limit of 3 vol.%, the automatic soldering line is started.

IBM Technical Disclosure Bulletin, Vol. 20, No. 6, Nov. 1977, 2318 discloses the manufacture of a circuit module in which solder balls connect a semiconductor chip to conductive pads on a ceramic substrate, wherein the unsoldered assembly is placed in an oven to melt the solder. The oven has an atmosphere of an inert gas, such as nitrogen, containing about 6000 ppm oxygen to thereby form on the solder a thin layer of oxide that protects the underlying solder from contaminants. The value of the oxygen concentration is chosen to produce an oxide film that is thick enough to cover the solder, but not to form a thick layer that may be brittle.

It would be an advantage to have a coating method which provides improved wetting between the metal-comprising coating material and the metal-comprising substrate, reduces the production rate of undesirable metal oxides, and does not require the addition of a wetting agent to the metal-comprising coating material.

In conformity with the subject invention a reflow coating method of applying a metal-comprising coating to a substrate on a circuit board, said method comprising:
a) providing an assembly comprising a metal-comprising coating material which is in contact with at least one substrate to which said metal-comprising coating material is to be bonded; and
b) heating said assembly to a temperature at which said metal comprising coating material is sufficiently fluid and active to bond to said substrate,
is characterized in that said heating is carried out in an oxidizing atmosphere which is controlled to a set point which provides an oxidizing capability greater than that required to oxidize said coating material, but having less oxidizing capability than that of air, said oxidizing capability corresponding with an oxidizing capability range equivalent to a nitrogen-based atmosphere having an oxygen-concentration ranging from about 10 ppm to about 100 000 ppm, and said set point being selected to provide good wetting of said substrate by said coating while reducing the amount of metal oxides formed and decreasing the occurence of discoloration and white haze on the circuit board.

The method of the present invention comprises conducting reflow coating operations in an oxidizing atmosphere having a controlled oxidation capability. The composition of the oxidizing atmosphere is controlled to a set point so the oxidation capability of the atmosphere is less than that of air, but greater than that which will reduce metal oxides. Typically the atmosphere is oxygen-comprising and the oxygen content is controlled at or about the set point. The set point corresponds with an oxygen concentration range from about 10 parts per million (ppm) to about 100 000 ppm (10 % by volume). The oxidizing atmosphere particularly may be controlled to at least plus or minus 30 percent of the aforementioned set point.

Preferably the atmosphere consists essentially of an inert gas and oxygen. The preferred oxidizing capability corresponds with an oxidizing capability range to a nitrogen-based atmosphere having an oxygen concentration ranging from greater than about 100 ppm to about 100 000 ppm; over this oxygen concentration range there is good wetting of the circuit board metal-comprising substrate surface by the coating material, e.g. solder, and white haze formation is avoided. White haze is a residue commonly remaining on circuit boards after cleaning. It is a tin-flux compound which forms in the presence of high oxygen concentrations, such as that of air.

Examples of inert gases which can be used in the present invention include nitrogen, argon, hydrogen, helium, water vapor, carbon dioxide and mixtures thereof. One of the most preferred inert gases for use in the present invention is nitrogen due to low cost and non-toxicity.

The metal portion of the metal-comprising coating particularly may be selected from the group consisting of tin, lead, antimony, silicon, indium, bismuth, silver, gold, and alloys thereof.

When coating is conducted in the absence of a flux, the desired oxygen concentration (in an atmosphere consisting substantially of nitrogen and oxygen) will decrease and the allowed variability will be less.

### Brief description of the drawings:

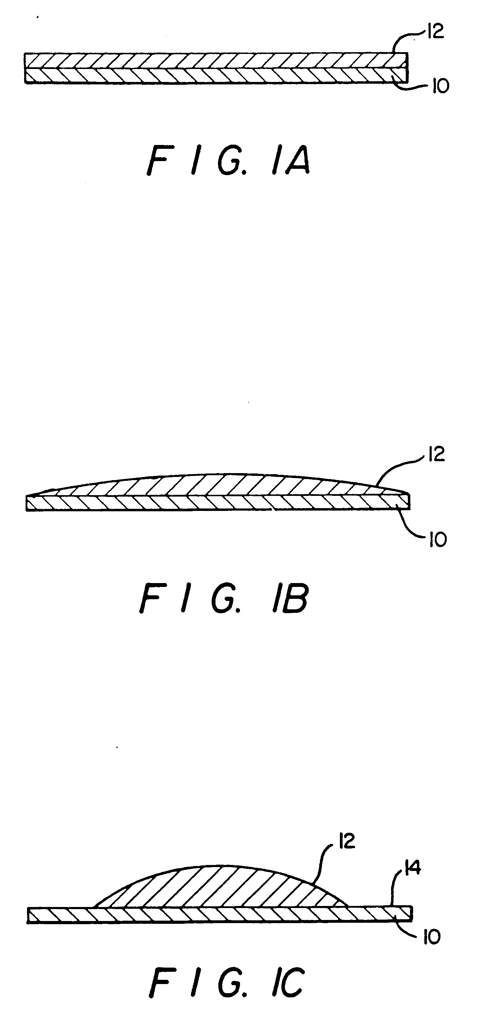

- Fig. 1A: shows a substrate such as copper which has been electroplated with solder.
- Fig. 1B: shows the structure obtained when an electroplated substrate of the type shown in Fig. 1A is reflowed and the surrounding atmosphere comprises oxygen at a concentration of greater than 100 ppm.
- Fig. 1C: shows the reflow structure obtained when the surrounding atmosphere comprises oxygen at a concentration of 100 ppm or less.

The method of the present invention comprises conducting coating operations in an oxidizing atmosphere having a limited and controlled oxidation capability. It is important that the atmosphere in the immediate space surrounding the coating operation have sufficient oxidation capability to form a limited number of compounds comprising metal-comprising coating elements, thus reducing the surface tension of the metal-comprising coating material and preventing such materials from pulling into droplets instead of wetting the substrate surface as desired. Simultaneously, if the oxidation capability is too great, large amounts of compounds comprising metal-comprising coating material elements, such as metal oxides (dross), will be formed, and the presence of large amounts of such compounds can interfere with wetting of the substrate surface as well as provide a metal-comprising coating material composition and coated structures which do not function as desired.

Reflow coating has been and is presently done both in air and in atmospheres which are low in oxygen concentration. In the past it has been thought that removal of oxygen in the atmosphere to the lowest concentration practical was desired, because absence of oxygen in the atmosphere surrounding the coating operation offered the benefit of less discoloration of the circuit boards, less flux degradation, resulted in easier cleaning of the circuit board after coating, and provided better wetting of the substrates by the coating material. However, it was discovered that use of atmospheres having too low an oxygen concentration has a deleterious effect on reflow coating.

For example, FIG. 1A shows a cross-sectional sketch of a substrate 10, the upper surface of which has an electroplated layer of solder 12 thereon. FIG. 1B shows a cross-sectional sketch of the FIG. 1A structure after reflow in an atmosphere comprising more than 100 ppm of oxygen. FIG. 1C shows a cross-sectional sketch of the FIG. 1A structure after reflow in an atmosphere comprising less than 100ppm of oxygen, wherein the solder dewets from the surface 14 of substrate 10, leaving the substrate exposed.

Experiments were conducted to determine the range of oxygen concentrations in a nitrogen-based atmosphere which would be high enough to prevent dewetting, but low enough to prevent discoloration of the circuit boards and to prevent the formation of white haze. Some discoloration of the circuit boards is tolerated in the industry, although presence of discoloration may raise concerns that the board has been damaged in some manner. White haze refers to a residue remaining on the circuit board following soldering and subsequent cleaning of the soldered board. The white haze is believed to be a compound formed by a reaction between the tin component of commonly used solders and components present in the flux. White haze is not significantly conductive, but does provide a source of capacitance which can lead to a short under high frequency operational conditions. In addition, many coatings used in the electronics industry to protect the finalized circuit board will not adhere to the white haze compound. Thus, it is highly desirable to have a circuit board which is free from white haze.

Circuit boards comprising epoxy-glass laminate material were initially electroplated with a 60:40 tin-lead solder on top of copper circuitry. The boards were coated with RMA flux and heated in an oven to a maximum temperature between 220°C and 240°C. The total time for heating and cooling of the boards was about 5 minutes. The atmosphere comprised dry nitrogen (typically containing less than 10 ppm oxygen) with controlled additions of oxygen. Additions of water vapor and hydrogen were made to the atmosphere used in specific experiments to determine whether the presence of these common gas additives would help prevent dewetting of the solder from the substrate surface. After reflow, the flux was cleaned off the surface of the boards using Freon TMS+, a product of DuPont Company which comprises a blend of freon 113, methanol and stabilizers. The reflowed circuit boards were examined visually for dewetting, discoloration and white haze after cleaning. The results are summarized in TABLE 1, below.

**TABLE 1**

| EFFECT OF ATMOSPHERE OXYGEN CONCENTRATION ON SOLDER DEWETTING, BOARD DISCOLORATION, AND WHITE HAZE | | | | |
|---|---|---|---|---|
| ATMOSPHERE | ppm O₂ | DEWETTING | DISCOLOR | WHITE HAZE |
| nitrogen | 100 ppm or less | yes | no | no |
| nitrogen | 1,000 | no | no | no |
| nitrogen | 2,500 | no | no | no |
| nitrogen | 6,000 | no | no | no |
| nitrogen | 30,000 | no | no | no |
| nitrogen | 50,000 | no | yes | no data |
| air | 210,000 | no | yes | yes |
| nitrogen with 2.5% water vapor | 100 ppm or less | yes | no | no |
| nitrogen with 5.0% hydrogen | 100 ppm or less | yes | no | no |

Controlled atmosphere oxygen concentrations should be beneficial for processes in general where a thin coating of molten metal is put upon a metal substrate, since presence of the controlled oxygen concentration reduces metal oxidation from that which would occur in atmospheres such as air, without causing the molten metal to dewet from the substrate surface, as can occur when the atmosphere oxygen concentration is about 100 ppm or less. It is believed controlled atmosphere oxygen concentrations would be advantageous in fluxless coating applications also. The controlled oxygen concentrations preferred in fluxless applications have not yet been determined, but will be lower than when a flux is used. In addition, the allowable variability in oxygen concentration of the atmosphere will be less for fluxless applications.

The oxidizing capability of the coating process atmosphere can be controlled to the desired set point by numerous techniques which would be apparent to one skilled in the art. One of the more common techniques is to control the composition of a gas which passes through the processing area, providing the desired atmosphere surrounding the coating operation.

As previously discussed, the most preferred inert gas for use in combination with oxygen at the specified concentrations is nitrogen due to its cost and non-toxicity. Cryogenic nitrogen, supplied via vaporization of liquid nitrogen, typically has an oxygen concentration of less than 10 ppm oxygen. Other forms of nitrogen which are commercially available include pressure swing absorption generated nitrogen and membrane generated nitrogen. The oxygen contents of these forms of nitrogen range from about 1,000 to about 50,000ppm oxygen. These latter two sources of nitrogen can be much less expensive than cryogenic nitrogen. If the available nitrogen source does not provide the desired oxygen concentration, it can be adjusted in a manner which will provide the desired oxygen concentration by adding either nitrogen, oxygen, or air to the available nitrogen source.

## Claims

1. A reflow coating method of applying a metal-comprising coating to a substrate on a circuit board, said method comprising:
(a) providing an assembly comprising a metal-comprising coating material which is in contact with at least one substrate to which said metal-comprising coating material is to be bonded; and
(b) heating said assembly to a temperature at which said metal comprising coating material is sufficiently fluid and active to bond to said substrate,
characterized in that said heating is carried out in an oxidizing atmosphere which is controlled to a set point which provides an oxidizing capability greater than that required to oxidize said coating material, but having less oxidizing capability than that of air, said oxidizing capability corresponding with an oxidizing capability range equivalent to a nitrogen-based atmosphere having an oxygen concentration ranging from about 10 ppm to about 100 000 ppm, and said set point being selected to provide good wetting of said substrate by said coating while reducing the amount of metal oxides formed and decreasing the occurence of discoloration and white haze on the circuit board.

2. The method as in claim 1 wherein said oxidizing atmosphere is controlled to at least plus or minus 30 percent of said set point.

3. The method of any one of the preceding claims wherein said oxidizing capability corresponds with an oxidizing capability range equivalent to a nitrogen-based atmosphere having an oxygen concentration ranging from greater than about 100 ppm to about 100 000 ppm.

4. The method of any one of the preceding claims wherein the metal portion of said metal-comprising coating is selected from the group consisting of tin, lead, antimony, silicon, indium, bismuth, silver, gold and alloys thereof.

5. The method of any one of the preceding claims wherein said contacting atmosphere comprises an inert gas and oxygen.

6. The method of claim 5 wherein said inert gas is selected from the group consisting of nitrogen, argon, hydrogen, helium, water vapor, carbon dioxide and mixtures thereof.

## Patentansprüche

1. Schmelzbeschichtungsverfahren zum Aufbringen einer metallhaltigen Beschichtung auf ein Substrat auf einer Leiterplatte, bei dem:
a) eine Anordnung vorgesehen wird, die einen metallhaltigen Beschichtungswerkstoff in Kontakt mit mindestens einem Substrat aufweist, mit dem der metallhaltige Beschichtungswerkstoff zu verbinden ist; und
b) diese Anordnung auf eine Temperatur erhitzt wird, bei welcher der metallhaltige Beschichtungswerkstoff ausreichend fluid und aktiv ist, um mit dem Substrat verbunden zu werden,
dadurch gekennzeichnet, daß das Erhitzen in einer oxidierenden Atmosphäre durchgeführt wird, die auf einen Sollwert eingestellt wird, der für ein Oxidationsvermögen sorgt, das größer als das zum Oxidieren des Beschichtungswerkstoffes erforderliche Oxidationsvermögen ist, aber ein geringeres Oxidationsvermögen als das von Luft hat, wobei dieses Oxidationsvermögen einem Oxidationsvermögensbereich entspricht, der äquivalent einer auf Stickstoff basierenden Atmosphäre ist, die eine Sauerstoffkonzentration im Bereich von etwa 10 ppm bis etwa 100 000 ppm hat, und wobei dieser Sollwert so gewählt wird, daß für eine gute Benetzung des Substrats durch die Beschichtung gesorgt ist, während die Menge von gebildeten Metalloxiden reduziert wird und das Auftreten von Verfärbung und weißem Schleier auf der Leiterplatte vermindert wird.

2. Verfahren nach Anspruch 1, bei dem die oxidierende Atmosphäre auf mindestens plus oder minus 30 % des Sollwertes eingestellt wird.

3. Verfahren nach einem der vorhergehenden Ansprüche, bei dem das Oxidationsvermögen einem Oxidationsvermögensbereich entspricht, der äquivalent einer auf Stickstoff basierenden Atmosphäre ist, die eine Sauerstoffkonzentration im Bereich von mehr als etwa 100 ppm bis etwa 100 000 ppm hat.

4. Verfahren nach einem der vorhergehenden Ansprüche, bei dem der Metallanteil der metallhaltigen Beschichtung aus der aus Zinn, Blei, Antimon, Silizium, Indium, Wismut, Silber, Gold und deren Legierungen bestehenden Gruppe ausgewählt ist.

5. Verfahren nach einem der vorhergehenden Ansprüche, bei dem die Kontaktatmosphäre ein inertes Gas und Sauerstoff aufweist.

6. Verfahren nach Anspruch 5, bei dem das inerte Gas aus der aus Stickstoff, Argon, Wasserstoff, Helium, Wasserdampf, Kohlendioxid und Gemischen derselben bestehenden Gruppe ausgewählt wird.

## Revendications

1. Procédé de revêtement par refusion pour appliquer un revêtement comprenant un métal à un substrat sur une plaquette à circuit, ledit procédé consistant :
(a) à utiliser un assemblage comportant une matière de revêtement comprenant un métal qui est en contact avec au moins un substrat auquel ladite matière de revêtement comprenant un métal doit être liée ; et
(b) à chauffer ledit assemblage à une température à laquelle ladite matière de revêtement comprenant un métal est suffisamment fluide et active pour se lier audit substrat,
caractérisé en ce que ledit chauffage est effectué dans une atmosphère oxydante qui est régulée à un point de réglage qui procure un pouvoir oxydant supérieur à celui demandé pour oxyder ladite matière de revêtement, mais ayant un pouvoir oxydant inférieur à celui de l'air, ledit pouvoir oxydant correspondant à une plage de pouvoir oxydant équivalente à une atmosphère à base d'azote ayant une concentration d'oxygène allant d'environ 10 ppm à environ 100 000 ppm, et ledit point de réglage étant choisi pour procurer un bon mouillage dudit substrat par ledit revêtement tout en réduisant la quantité d'oxydes métalliques formés et en diminuant l'apparition d'une décoloration et d'un voile étendu sur la plaquette à circuit.

2. Procédé selon la revendication 1, dans lequel ladite atmosphère oxydante est régulée à au moins plus ou moins 30 pour cent dudit point de réglage.

3. Procédé selon l'une des revendications précédentes, dans lequel ledit pouvoir oxydant correspond à une plage de pouvoir oxydant équivalente à une atmosphère à base d'azote ayant une concentration d'oxygène allant de plus d'environ 100 ppm jusqu'à environ 100 000 ppm.

4. Procédé selon l'une quelconque des revendications précédentes, dans lequel la partie métallique dudit revêtement comprenant du métal est choisie dans le groupe constitué de l'étain, du plomb, de l'antimoine, du silicium, de l'indium, du bismuth, de l'argent, de l'or et d'alliages de ceux-ci.

5. Procédé selon l'une quelconque des revendications précédentes, dans lequel ladite atmosphère de mise en contact comprend un gaz inerte et de l'oxygène.

6. Procédé selon la revendication 5, dans lequel ledit gaz inerte est choisi dans le groupe constitué de l'azote, de l'argon, de l'hydrogène, de l'hélium, de la vapeur d'eau, de l'anhydride carbonique et de mélanges de ceux-ci.
